(19) Europäisches Patentamt / European Patent Office / Office européen des brevets

(11) **EP 4 787 469 A1**

## (12) EUROPEAN PATENT APPLICATION
published in accordance with Art. 153(4) EPC

(43) Date of publication:
**05.08.2026 Bulletin 2026/32**

(21) Application number: **24886381.3**

(22) Date of filing: **01.11.2024**

(51) International Patent Classification (IPC):
*H01M 4/36* (2006.01)      *H01M 4/525* (2010.01)
*H01M 4/505* (2010.01)      *H01M 4/131* (2010.01)
*H01M 10/052* (2010.01)      *C01G 53/00* (2025.01)
*C30B 29/22* (2006.01)      *H01M 4/02* (2006.01)

(52) Cooperative Patent Classification (CPC):
**C01G 53/00; C30B 29/22; H01M 4/02; H01M 4/131;
H01M 4/36; H01M 4/505; H01M 4/525;
H01M 10/052; Y02E 60/10**

(86) International application number:
**PCT/KR2024/017100**

(87) International publication number:
**WO 2025/095711 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.11.2023 KR 20230151120**

(71) Applicant: **LG Chem, Ltd.**
**Seoul 07336 (KR)**

(72) Inventors:
• **SHIN, Ji A**
**Daejeon 34122 (KR)**
• **HEO, Un Seon**
**Daejeon 34122 (KR)**
• **LEE, Jee Ho**
**Daejeon 34122 (KR)**
• **KIM, Sun Cheol**
**Daejeon 34122 (KR)**
• **LIM, Seung Woo**
**Daejeon 34122 (KR)**
• **SHIN, Ye Won**
**Daejeon 34122 (KR)**
• **YOU, Min Kyu**
**Daejeon 34122 (KR)**

(74) Representative: **Hoffmann Eitle**
**Patent- und Rechtsanwälte PartmbB**
**Arabellastraße 30**
**81925 München (DE)**

(54) **CATHODE ACTIVE MATERIAL, PREPARATION METHOD THEREFOR, AND CATHODE AND LITHIUM SECONDARY BATTERY COMPRISING SAME**

(57) The present invention relates to a positive electrode active material capable of enhancing the performance of a lithium secondary battery, the positive electrode active material including a lithium composite transition metal oxide in the form of a single particle formed of 10 or fewer primary particles, and having a nickel (Ni) content of 50 mol% or greater among all metals excluding lithium, and a coating layer comprising aluminum (Al) and tungsten (W) formed on the lithium composite transition metal oxide, a method for preparing the same, and a positive electrode and a lithium secondary battery which include the same.

[FIG. 1]

**Description**

## TECHNICAL FIELD

## Cross-reference to Related Applications

The present application claims the benefit of the priority of Korean Patent Application No. 10-2023-0151120, filed on November 3, 2023, which is hereby incorporated by reference in its entirety.

## Technical Field

The present invention relates to a positive electrode active material, a method for preparing the same, and a positive electrode and a lithium secondary battery which include the same.

## BACKGROUND ART

Demand for secondary batteries as an energy source is on a rapid rise, resulting from technology development and a growing demand for mobile devices. Among such secondary batteries, lithium secondary batteries exhibiting high energy density and voltage, long cycle life, and low self-discharging rate have been commercially available and widely used.

Lithium composite transition metal oxides have been used as a positive electrode active material of the lithium secondary battery, and in particular, a lithium cobalt composite metal oxide, such as $LiCoO_2$, exhibiting a high working voltage and superior capacity characteristics has been primarily used. However, $LiCoO_2$ has fairly poor thermal properties due to an unstable crystal structure caused by delithiation and is also high-priced, and accordingly, has a limitation in being used as a power source in an area such as electric vehicles in a large amount.

Lithium manganese composite metal oxides ($LiMnO_2$, $LiMn_2O_4$, or the like), lithium iron phosphate compounds ($LiFePO_4$ or the like), or lithium nickel composite metal oxides ($LiNiO_2$ or the like) have been developed as materials for replacing $LiCoO_2$. Among these materials, research and development of the lithium nickel composite metal oxides, in which large capacity batteries are easily achieved due to a high reversible capacity of about 200 mAh/g, have been more actively conducted. However, $LiNiO_2$ has poorer thermal stability than $LiCoO_2$ and when an internal short circuit takes place in a charged state due to an external pressure, a positive electrode active material itself is decomposed to cause rupture and ignition of batteries.

Accordingly, as a method for retaining the superior reversible capacity of $LiNiO_2$ and mitigating the low thermal stability thereof, a nickel cobalt manganese-based lithium composite transition metal oxide, in which a portion of Ni is substituted with Mn and Co, a nickel manganese aluminum-based lithium composite transition metal oxide, and the like have been developed.

Typical nickel cobalt manganese-based lithium composite transition metal oxides are generally in the form of a spherical secondary particle in which several tens to several hundreds of primary particles are aggregated. However, as for the nickel cobalt manganese-based lithium composite transition metal oxides in the form of a secondary particle in which a number of primary particles are aggregated, the detachment of primary particles, that is, the breakage of particles, easily takes place in a rolling process in the manufacture of a positive electrode, and cracks are generated inside particles in a charging/discharging process. When the breakage or cracking of positive electrode active material particles is caused, a contact area with an electrolyte is increased to exacerbate gas generation and degradation of active materials, which are caused by side reactions with an electrolyte.

Meanwhile, a lithium composite transition metal oxide having a nickel content of 50 mol% or greater among all metals excluding lithium in the lithium composite transition metal oxide exhibits further degradation in structural and chemical stability, presents greater challenges in achieving thermal stability, and incurs higher costs due to the need for high-temperature processing.

Consequently, there is a need to develop positive electrode active materials allowing for lithium secondary batteries with enhanced capacity characteristics and lifespan characteristics.

[Prior Art Documents]

[Patent Document]

(Patent Document 1) Korean Patent Application Publication No. 10-2021-0007808

## DISCLOSURE OF THE INVENTION

## TECHNICAL PROBLEM

The present invention is designed to overcome the limitations described above, and thus, an aspect of the present invention provides a positive electrode active material capable of enhancing battery capacity, output, and lifespan characteristics and a method for preparing the same.

Another aspect of the present invention provides a positive electrode and a lithium secondary battery exhibiting superior capacity, output, and lifespan characteristics, including the positive electrode active material.

## TECHNICAL SOLUTION

(1) According to an aspect of the present invention, provided is a positive electrode active material including a lithium composite transition metal oxide in the form of a single particle formed of 10 or fewer primary particles, and having a nickel (Ni) content of 50 mol% or greater among all metals excluding lithium, and a coating layer comprising aluminum (Al) and tungsten (W) formed on the lithium composite transition metal oxide.

(2) The present invention provides the positive electrode active material according to (1) above, wherein the lithium composite transition metal oxide has a Ni content of 59 mol% to 70 mol% among all metals excluding lithium.

(3) The present invention provides the positive electrode active material according to (1) or (2) above, wherein the lithium composite transition metal oxide has a composition represented by Formula 1 below.

[Formula 1]  $Li_{1+x}Ni_aCo_bMn_cM_dO_2$

In Formula 1 above, M is at least one selected from Zr, Y, B, Al, W, Mg, Ce, Hf, Ta, La, Ti, Sr, Ba, Ce, F, P, S, and La, and x, a, b, c, and d satisfy $-0.100 \leq x \leq 0.100$, $0.5900 \leq a < 1.0000$, $0 < b < 0.4100$, $0 < c < 0.4100$, and $0 \leq d \leq 0.1000$.

(4) The present invention provides the positive electrode active material according to any one of (1) to (3) above, wherein the lithium composite transition metal oxide has a single particle formation degree ($\chi$) of 0.40 or greater according to Equation 1 below.

[Equation 1]

$$\chi = \frac{\text{Average particle size of primary particle } (D'_{50}) \, [\mu m]}{\text{Average particle size of lithium composite transition metal oxide } (D_{50}) \, [\mu m]}$$

(5) The present invention provides the positive electrode active material according to (4) above, wherein the single particle formation degree ($\chi$) ranges from 0.55 to 0.65.

(6) The present invention provides the positive electrode active material according to any one of (1) to (5) above, wherein the primary particles have an average particle size ($D'_{50}$) of 1.0 $\mu$m to 3.5 um.

(7) The present invention provides the positive electrode active material according to any one of (1) to (6) above, wherein the lithium composite transition metal oxide has an average particle size ($D_{50}$) of 2.0 $\mu$m to 5.0 $\mu$m.

(8) The present invention provides the positive electrode active material according to any one of (1) to (7) above, wherein the lithium composite transition metal oxide has an average crystallite size of 120 nm to 200 nm.

(9) The present invention provides the positive electrode active material according to any one of (1) to (8) above, wherein the coating layer is provided in an amount of 0.01 parts by weight to 1.00 part by weight with respect to 100 parts by weight of the lithium composite transition metal oxide.

(10) The present invention provides the positive electrode active material according to any one of (1) to (9) above, wherein the coating layer contains aluminum (Al) in an amount of 500 ppm to 4000 ppm with respect to a total weight of the lithium composite transition metal oxide.

(11) The present invention provides the positive electrode active material according to any one of (1) to (10) above, wherein the coating layer contains tungsten (W) in an amount of 1000 ppm to 4000 ppm with respect to a total weight of the lithium composite transition metal oxide.

(12) The present invention provides the positive electrode active material according to any one of (1) to (11) above, wherein the coating layer includes at least one selected from an M'-O compound and a Li-M'-O compound, and M' is at least one selected from Al and W.

(13) The present invention provides the positive electrode active material according to any one of (1) to (12) above, wherein the coating layer is of a film type, island type, or a combination of both.

(14) The present invention provides the positive electrode active material according to any one of (1) to (13) above, wherein the positive electrode active material has an average particle size of 2.0 μm to 5.0 μm.

(15) According to another aspect of the present invention, provided is a method for preparing the positive electrode active material according to (1) above, including (A) mixing and firing a composite transition metal hydroxide and a lithium (Li)-containing raw material to prepare a lithium composite transition metal oxide, and (B) mixing the lithium composite transition metal oxide with an aluminum (Al)-containing raw material and a tungsten (W)-containing raw material to prepare a mixture, and then heat treating the mixture to form a coating layer including aluminum (Al) and tungsten (W) on the lithium composite transition metal oxide, wherein the firing is performed at a temperature of 900 °C to 1000 °C.

(16) The present invention provides the method according to (15) above, wherein the aluminum (Al)-containing raw material is mixed to achieve the aluminum (Al) in an amount of 500 ppm to 4000 ppm with respect to a total weight of the lithium composite transition metal oxide.

(17) The present invention provides the method according to (15) or (16) above, wherein the tungsten (W)-containing raw material is mixed to achieve the tungsten (W) in an amount of 500 ppm to 5500 ppm with respect to a total weight of the lithium composite transition metal oxide.

(18) The present invention provides the method according to any one of (15) to (17) above, wherein the aluminum (Al)-containing raw material is at least one selected from oxide, carbonate, nitrate, hydroxide, oxyhydroxide, and halide, containing aluminum (Al), and the tungsten (W)-containing raw material is at least one selected from oxide, carbonate, nitrate, hydroxide, oxyhydroxide, and halide, containing tungsten (W).

(19) The present invention provides the method according to any one of (15) to (18) above, wherein the heat treatment is performed at a temperature of 300 °C to 600 °C.

(20) According to another aspect of the present invention, provided is a positive electrode including the positive electrode active material according to any one of (1) to (14) above.

(21) According to another aspect of the present invention, provided is a lithium secondary battery including the positive electrode according to (20) above.

## ADVANTAGEOUS EFFECTS

A positive electrode active material according to the present invention includes a coating layer containing aluminum (Al) and tungsten (W) formed on a lithium composite transition metal oxide having a nickel content of 50 mol% or greater among all metals excluding lithium in the lithium composite transition metal oxide, and thus exhibits suppressed surface degradation and improved electrical conductivity. Accordingly, a positive electrode and a secondary battery which include the positive electrode active material achieve enhanced capacity characteristics, output characteristics, and lifespan characteristics.

In addition, according to a method for preparing a positive electrode active material of the present invention, the positive electrode active material described above may be effectively prepared.

## BRIEF DESCRIPTION OF THE DRAWINGS

FIG. 1 is an SEM image showing a positive electrode active material prepared in Example 1;
FIG. 2 is an SEM image showing a positive electrode active material prepared in Comparative Example 1;
FIG. 3 is an EPMA nickel element mapping image for a positive electrode active material prepared in Example 1;
FIG. 4 is an EPMA aluminum element mapping image for a positive electrode active material prepared in Example 1; and
FIG. 5 is an EPMA tungsten element mapping image for a positive electrode active material prepared in Example 1.

## BEST MODE FOR CARRYING OUT THE INVENTION

Hereinafter, the present invention will be described in detail to aid in understanding of the present invention.

It will be understood that words or terms used in the specification and claims shall not be interpreted as the meaning defined in commonly used dictionaries, and it will be further understood that the words or terms should be interpreted as having a meaning that is consistent with their meaning in the context of the relevant art and the technical idea of the invention, based on the principle that an inventor may properly define the meaning of the words or terms to best explain the invention.

Herein, it will be further understood that the terms 'include', 'comprise', or 'have' specify the presence of stated features, numbers, steps, elements, or combinations thereof, but do not preclude the presence or addition of one or more other features, numbers, steps, elements, or combinations thereof.

Herein, the term 'on' indicates a case in which a certain component is formed directly on an upper surface of another component, and also a case in which a third component is interposed between these components.

Herein, a 'single particle form' is a concept in contrast to a spherical secondary particle form, in which tens to hundreds of primary particles are aggregated, formed through typical methods, and indicates a form made up of 10 or fewer primary particles. Specifically, the single particle form herein may be in the form of a single particle formed of one primary particle or in the form of a secondary particle formed by aggregated several primary particles.

Herein, a 'primary particle' indicates a smallest unit of particles recognized when observing a positive electrode active material through a scanning electron microscope (SEM), and a 'secondary particle' indicates a secondary structure where a plurality of primary particles are aggregated.

Herein, the content of each element in a lithium composite transition metal oxide may be measured through inductive coupled plasma (ICP) analysis using an inductively coupled plasma optical emission spectrometer (ICP-OES; Aligent5110, Aligent).

Herein, a particle size of primary particles may be determined by calculating an area of each primary particle based on the number of pixels corresponding to each of the n primary particles present in an SEM image and measuring a particle size of each primary particle present in the SEM image using the radius of a circle having the same area as each primary particle. In addition, herein, an average particle size ($D'_{50}$) of primary particles may be defined as a particle size at a cumulative volume distribution of 50% in a particle size distribution curve (curve on the graph of a particle size distribution) of each particle. The average particle size ($D'_{50}$) of primary particles may be determined by calculating a particle diameter at 50% of the cumulative distribution of volume according to the particle size from the results of calculating volume of the primary particle, which is defined by the volume of a sphere whose radius is half of the particle size of the primary particle.

Herein, an average particle size ($D_{50}$) of lithium composite transition metal oxide and an average particle size of a positive electrode active material may be defined as a particle size at a cumulative volume distribution of 50% in a particle size distribution curve (curve on the graph of a particle size distribution) of each particle. After dispersing measurement target powder in a dispersion medium, the dispersion medium is introduced into a commercial laser diffraction particle size measurement instrument (e.g., S3500 from Microtrac), a particle size distribution is calculated by measuring a difference in diffraction patterns due to a particle size when particles pass through a laser beam, and a particle diameter at 50% of the cumulative distribution of volume according to the particle size using the measurement instrument is calculated to determine the average particle size ($D_{50}$) of lithium composite transition metal oxide and the average particle size of the positive electrode active material.

Herein, a crystallite indicates a particle unit having substantially the same crystal orientation.

Herein, an 'average crystallite size' may be quantitatively analyzed using X-ray diffraction analysis (XRD) by Cu K$\alpha$ X-rays. Specifically, the average crystallite size may be quantitatively analyzed by placing particles to be measured in a holder, irradiating the particles with X-rays, and analyzing the resulting diffraction grating. Sampling was prepared by placing a powder sample of particles to be measured into a groove at the center of a general powder holder, leveling a surface using a slide glass, and making the sample height the same as an edge of the holder. Then, X-ray diffraction analysis was performed using a Bruker D8 Endeavor (light source: Cu K$\alpha$, $\lambda$=1.54 Å) equipped with a LynxEye XE-T position sensitive detector, with a FDS of 0.5°, a step size of 0.02°, and a total scan time of about 20 minutes in the range of $2\theta$=15° to 80°. Rietveld refinement was performed on the measured data, considering the charge at each site (+3 for metal ions at the transition metal site, +2 for Ni ions at the Li site) and cation mixing. Instrumental broadening was considered in the crystallite size analysis using Fundamental Parameter Approach (FPA) implemented in the Bruker TOPAS program, and the entire peaks in the measurement range were used for fitting. Peak shape was fitted using only Lorentzian contribution with FP (First Principle) among the peak types available in TOPAS, and strain was not considered in this case.

## Positive electrode active material

Hereinafter, a positive electrode active material according to the present invention will be described.

The positive electrode active material according to the present invention includes a lithium composite transition metal oxide in the form of a single particle formed of 10 or fewer primary particles, and having a nickel (Ni) content of 50 mol% or greater among all metals excluding lithium, and a coating layer comprising aluminum (Al) and tungsten (W) formed on the lithium composite transition metal oxide.

The lithium composite transition metal oxide is in the form of a single particle composed of 10 or fewer primary particles. That is, the lithium composite transition metal oxide is in the form of a one-body particle or a single particle in which 2 to 10 particles are aggregated. The single particle form is distinct from a secondary particle in which more than 10 primary particles are aggregated. When in the form of a single particle, the lithium composite transition metal oxide exhibits superior stability. Thus, a positive electrode active material including the lithium composite transition metal oxide, even when rolled, is prevented from breakage or cracks, and accordingly, side reactions between the positive electrode active material and an electrolyte may be reduced. Consequently, batteries may have improved durability against volume changes during charge and discharge, resulting in enhanced lifespan characteristics. When the lithium composite transition metal oxide is in the form of a secondary particle, a positive electrode active material including the lithium composite transition metal oxide undergoes breakage or cracks, and accordingly, poor lifespan characteristics may be induced due to side reactions between the positive electrode active material and an electrolyte.

The lithium composite transition metal oxide has a nickel (Ni) content of 50 mol% or greater among all metals excluding lithium. When the nickel (Ni) content is within the above range, the positive electrode active material may have enhanced capacity characteristics. Specifically, when the content of Ni is in a range of 59 mol% to 70 mol%, capacity characteristics may be improved without compromising lifespan characteristics. When the content of nickel (Ni) among all metals excluding lithium is less than 50 mol%, the positive electrode active material may exhibit poor charge/discharge capacity.

The inventors have found that, when a lithium composite transition metal oxide having a nickel (Ni) content of 50 mol% or greater among all metals excluding lithium is used, and a coating layer containing aluminum (Al) and tungsten (W) is included on the lithium composite transition metal oxide, specifically, when the coating layer contains aluminum (Al): degradation of a positive electrode surface due to a side reaction between hydrogen fluoride and an electrolyte may be suppressed by removing hydrogen fluoride; when the coating layer contains tungsten (W): electrical conductivity may be improved to enhance output characteristics; and when the coating layer contains both aluminum (Al) and tungsten (W): due to the property of aluminum (Al) forming a coating layer in a nano particle size, the coating layer containing aluminum (Al) and tungsten (W) may suppress the elution of metal ions of a positive electrode active material, leading to improved capacity characteristics and lifespan characteristics of the positive electrode active material, thereby completing the invention.

Meanwhile, when a coating layer containing aluminum (Al) and tungsten (W) is not included on a lithium composite transition metal oxide having a nickel (Ni) content of 50 mol% or greater among all metals excluding lithium in the lithium composite transition metal oxide, capacity characteristics, output characteristics, and lifespan characteristics are damaged due to low electrical conductivity and degradation of a positive electrode surface caused by a side reaction between hydrogen fluoride of the positive electrode active material and an electrolyte.

According to an embodiment of the present invention, the lithium composite transition metal oxide has a composition represented by Formula 1 below.

$$[\text{Formula 1}] \qquad Li_{1+x}Ni_aCo_bMn_cM_dO_2$$

In Formula 1 above,

M is at least one selected from Zr, Y, B, Al, W, Mg, Ce, Hf, Ta, La, Ti, Sr, Ba, Ce, F, P, S, and La, and
x, a, b, c, and d satisfy $-0.100 \leq x \leq 0.100$, $0.5900 \leq a < 1.0000$, $0 < b < 0.4100$, $0 < c < 0.4100$, and $0 \leq d \leq 0.1000$.

M is a doping element, and specifically, M may be at least one selected from Zr, Y, B, Al, W, Mg, Ce, Hf, Ta, La, Ti, Sr, Ba, Ce, F, P, S, and La. M is not necessarily included, but when included in an appropriate amount, the positive electrode active material may exhibit improved particle shape and enhanced crystal structure stability. Specifically, M may be at least one selected from Zr and Y. In this case, M may serve as a flux to obtain uniform particle size and particle shape of the positive electrode active material.

Meanwhile, x may be -0.100 or greater, -0.090 or greater, -0.080 or greater, -0.070 or greater, -0.060 or greater, -0.050 or greater, -0.040 or greater, -0.030 or greater, -0.020 or greater, -0.010 or greater, 0 or greater, 0.010 or greater, or 0.020 or greater, and may be 0.030 or less, 0.040 or less, 0.050 or less, 0.060 or less, 0.070 or less, 0.080 or less, 0.090 or less, or 0.100 or less. When x satisfies the above range, high capacity characteristics and high energy density per unit volume may be achieved.

a is a mole fraction of nickel (Ni) among all metals excluding lithium in the lithium composite transition metal oxide, and may be 0.5900 or greater, and may be 0.6000 or less, 0.6100 or less, 0.6200 or less, 0.6300 or less, 0.6400 or less, 0.6500 or less, 0.6600 or less, 0.6700 or less, 0.6800 or less, 0.6900 or less, 0.7000 or less, 0.8000 or less, 0.9000 or less, or less than 1.0000. When a is within the above range, the positive electrode active material may have enhanced capacity characteristics. In particular, when a is in a range of 0.5900 to 0.7000, the positive electrode active material may exhibit improved structural stability and thermal stability along with superior price competitiveness.

b is a mole fraction of cobalt (Co) among all metals excluding lithium in the lithium composite transition metal oxide, and may be greater than 0, 0.0100 or greater, 0.0200 or greater, 0.0300 or greater, or 0.0400 or greater, and may be 0.0500 or less, 0.0600 or less, 0.0700 or less, 0.0800 or less, 0.0900 or less, 0.1000 or less, 0.2000 or less, 0.2500 or less, 0.3000 or less, 0.3500 or less, or less than 0.4100. When b satisfies the above range, output characteristics during a process of charge/discharge may be improved.

c is a mole fraction of manganese (Mn) among all metals excluding lithium in the lithium composite transition metal oxide, and may be greater than 0, 0.1000 or greater, 0.1500 or greater, 0.2000 or greater, 0.2500 or greater, 0.300 or greater, 0.3100 or greater, 0.3200 or greater, 0.3300 or greater, or 0.3400 or greater, and may be 0.3500 or less, 0.3600 or less, 0.3700 or less, 0.3800 or less, 0.3900 or less, 0.4000 or less, or less than 0.4100. When c satisfies the above range, structural stability may increase and an electrolyte may exhibit relatively reduced decomposition reactions.

d is a molar ratio of M among all metals excluding lithium in the lithium composite transition metal oxide, and may be 0 or greater, 0.0010 or greater, 0.0020 or greater, 0.0030 or greater, or 0.0040 or greater, and may be 0.0050 or less, 0.0060 or less, 0.0070 or less, 0.0080 or less, 0.0090 or less, 0.0100 or less, 0.0200 or less, 0.0300 or less, 0.0400 or less, 0.0500 or less, 0.0600 or less, 0.0700 or less, 0.0800 or less, 0.0900 or less, or 0.1000 or less. When d satisfies the above range, the positive electrode active material may exhibit enhanced crystal structure stability and improved particle shape.

a, b, c, and d may satisfy a+b+c+d=1.

Herein, single particle formation degree is evaluated and indicated as a parameter represented by Equation 1 below. The single particle formation degree indicated in the present invention is a value adjusted according to an average particle size ($D'_{50}$) of primary particles forming a single particle and an average particle size ($D_{50}$) of a lithium composite transition metal oxide in the form of a single particle, and a higher degree of single particle formation is observed when the average particle size ($D'_{50}$) of primary particles present in the lithium composite transition metal oxide is closer to the average particle size ($D_{50}$) of the lithium composite transition metal oxide.

For example, a maximum value of the single particle formation degree is 1, which indicates that one single particle is composed of one primary particle.

According to an embodiment of the present invention, the lithium composite transition metal oxide may have a single particle formation degree ($\chi$) of 0.40 or greater according to Equation 1 below.

[Equation 1]

$$\chi = \frac{\text{Average particle size of primary particle } (D'_{50}) \text{ } [\mu m]}{\text{Average particle size of lithium composite transition metal oxide } (D_{50}) \text{ } [\mu m]}$$

The single particle formation degree ($\chi$) may be 0.40 or greater, 0.45 or greater, 0.50 or greater, 0.55 or greater, 0.56 or greater, 0.57 or greater, 0.58 or greater, 0.59 or greater, or 0.60 or greater, and may be 0.61 or less, 0.62 or less, 0.63 or less, 0.64 or less, 0.65 or less, 0.66 or less, 0.67 or less, 0.68 or less, 0.69 or less, 0.70 or less, 0.71 or less, 0.72 or less, 0.73 or less, 0.74 or less, 0.75 or less, 0.76 or less, 0.77 or less, 0.78 or less, 0.79 or less, 0.80 or less, 0.81 or less, 0.82 or less, 0.83 or less, 0.84 or less, 0.85 or less, 0.86 or less, 0.87 or less, 0.88 or less, 0.89 or less, 0.90 or less, 0.91 or less, 0.92 or less, 0.93 or less, 0.94 or less, 0.95 or less, 0.96 or less, 0.97 or less, 0.98 or less, 0.99 or less, or 1.00 or less. When the above range is satisfied, it is seen that the lithium composite transition metal oxide of the present invention is in the form of a single particle with suppressed agglomeration between particles. Accordingly, the lithium composite transition metal oxide exhibits enhanced structural stability, leading to suppressed particle breakage during rolling for electrode manufacturing or cell operation, reduced grain boundary area in contact with an electrolyte, and reduced gas generation caused by side reactions with an electrolyte, and thus, secondary batteries may have improved lifespan characteristics. In particular, when the single particle formation degree ranges from 0.55 to 0.65, capacity characteristics may be improved without compromising lifespan characteristics.

According to an embodiment of the present invention, the primary particles may have an average particle size ($D'_{50}$) of 1.0 $\mu$m to 3.5 $\mu$m. Specifically, the primary particles may have an average particle size ($D'_{50}$) of 1.0 $\mu$m or greater, 1.1 $\mu$m or greater, 1.2 $\mu$m or greater, 1.3 $\mu$m or greater, 1.4 $\mu$m or greater, 1.5 $\mu$m or greater, 1.6 $\mu$m or greater, 1.7 $\mu$m or greater, 1.8 $\mu$m or greater, 1.9 $\mu$m or greater, 2.0 $\mu$m or greater, 2.1 $\mu$m or greater, or 2.2 $\mu$m or greater, and an average particle size ($D'_{50}$) of 2.3 $\mu$m or less, 2.4 $\mu$m or less, 2.5 $\mu$m or less, 2.6 $\mu$m or less, 2.7 $\mu$m or less, 2.8 $\mu$m or less, 2.9 $\mu$m or less, 3.0 $\mu$m or less, 3.1 $\mu$m or less, 3.2 $\mu$m or less, 3.3 $\mu$m or less, 3.4 $\mu$m or less, or 3.5 $\mu$m or less. When the average particle size ($D'_{50}$) of primary particles is within the above range, side reactions between a positive electrode active material and an electrolyte is reduced, and thus lifespan characteristics may be improved and resistance characteristics may be improved due to a reduced lithium diffusion path inside the particles.

According to an embodiment of the present invention, the lithium composite transition metal oxide may have an average particle size ($D_{50}$) of 2.0 $\mu$m to 5.0 $\mu$m. Specifically, the lithium composite transition metal oxide may have an average particle size ($D_{50}$) of 2.0 $\mu$m or greater, 2.1 $\mu$m or greater, 2.2 $\mu$m or greater, 2.3 $\mu$m or greater, 2.4 $\mu$m or greater, 2.5 $\mu$m or greater, 2.6 $\mu$m or greater, 2.7 $\mu$m or greater, 2.8 $\mu$m or greater, 2.9 $\mu$m or greater, 3.0 $\mu$m or greater, 3.1 $\mu$m or greater, 3.2 $\mu$m or greater, 3.3 $\mu$m or greater, 3.4 $\mu$m or greater, 3.5 $\mu$m or greater, 3.6 $\mu$m or greater, 3.7 $\mu$m or greater, or 3.8 $\mu$m or greater, and an average particle size ($D'_{50}$) of 3.9 $\mu$m or less, 4.0 $\mu$m or less, 4.1 $\mu$m or less, 4.2 $\mu$m or less, 4.3 $\mu$m or less, 4.4 $\mu$m or less, 4.5 $\mu$m or less, 4.6 $\mu$m or less, 4.7 $\mu$m or less, 4.8 $\mu$m or less, 4.9 $\mu$m or less, or 5.0 $\mu$m or less. When the average particle size ($D_{50}$) of the lithium composite transition metal oxide is within the above range, superior electrode density and improved capacity characteristics may be achieved.

According to an embodiment of the present invention, the lithium composite transition metal oxide may have an average crystallite size of 120 nm to 200 nm. Specifically, the average crystallite size may be 120 nm or greater, 130 nm or greater, 140 nm or greater, 150 nm or greater, 160 nm or greater, 170 nm or greater, or 180 nm or greater, and may be 190 nm or less, or 200 nm or less. When the average crystallite size is within the above range, the number of crystal planes within particles is small, and accordingly, even with repeated charging and discharging, there is less chance of microcracks from structural collapse forming along crystal planes and structural stability is high. Consequently, batteries including the lithium composite transition metal oxide may exhibit superior lifespan characteristics.

According to an embodiment of the present invention, the coating layer may be provided in an amount of 0.01 parts by weight to 1.00 part by weight with respect to 100 parts by weight of the lithium composite transition metal oxide. Specifically, the coating layer may be provided in an amount of 0.01 parts by weight or greater, 0.02 parts by weight or greater, 0.03 parts by weight or greater, 0.04 parts by weight or less, 0.05 parts by weight or greater, 0.06 parts by weight or greater, 0.07 parts by weight or greater, 0.08 parts by weight or greater, 0.09 parts by weight or greater, 0.10 parts by weight or greater, 0.15 parts by weight or greater, 0.20 parts by weight or greater, 0.25 parts by weight or greater, 0.30 parts by weight or greater, 0.35 parts by weight or greater, 0.40 parts by weight or greater, 0.45 parts by weight or greater, or 0.50 parts by weight or greater, and in an amount of 0.55 parts by weight or less, 0.60 parts by weight or less, 0.65 parts by weight or less, 0.70 parts by weight or less, 0.75 parts by weight or less, 0.80 parts by weight or less, 0.85 parts by weight or less, 0.90 parts by weight or less, 0.95 parts by weight or less, or 1.00 part by weight or less, with respect to 100 parts by weight of the lithium composite transition metal oxide. The coating layer, when provided in an amount within the above range, may serve to prevent surface degradation of the positive electrode active material without hindering the movement of lithium ions.

According to an embodiment of the present invention, the coating layer may contain aluminum (Al) in an amount of 500 ppm to 4,000 ppm with respect to a total weight of the lithium composite transition metal oxide. Specifically, the lithium composite transition metal oxide may contain aluminum (Al) in an amount of 500 ppm or greater, 600 ppm or greater, 700 ppm or greater, 800 ppm or greater, 900 ppm or greater, or 1000 ppm or greater, and in an amount of 1400 ppm or less, 1500 ppm or less, 1600 ppm or less, 1700 ppm or less, 1800 ppm or less, 1900 ppm or less, 2000 ppm or less, 2100 ppm or less, 2200 ppm or less, 2300 ppm or less, 2400 ppm or less, 2500 ppm or less, 2600 ppm or less, 2700 ppm or less, 2800 ppm or less, 2900 ppm or less, 3000 ppm or less, 3100 ppm or less, 3200 ppm or less, 3300 ppm or less, 3400 ppm or less, 3500 ppm or less, 3600 ppm or less, 3700 ppm or less, 3800 ppm or less, 3900 ppm or less, or 4000 ppm or less, with respect to a total weight of the lithium composite transition metal oxide. When the aluminum (Al) content is within the above range, batteries may exhibit improved lifespan characteristics by removing hydrogen fluoride and suppressing degradation of the positive electrode surface due to side reactions between hydrogen fluoride and an electrolyte.

According to an embodiment of the present invention, the coating layer may contain tungsten (W) in an amount of 10 00 ppm to 4000 ppm with respect to a total weight of the lithium composite transition metal oxide. Specifically, the lithium composite transition metal oxide may contain tungsten (W) in an amount of 1000 ppm or more, 1100 ppm or more, 1200 ppm or more, 1300 ppm or more, 1400 ppm or more, 1500 ppm or more, 1600 ppm or more, 1700 ppm or more, 1800 ppm or more, 1900 ppm or more, or 2000 ppm or more, and in an amount of 2400 ppm or less, 2500 ppm or less, 2600 ppm or less, 2700 ppm or less, 2800 ppm or less, 2900 ppm or less, 3000 ppm or less, 3100 ppm or less, 3200 ppm or less, 3300 ppm or less, 3400 ppm or less, 3500 ppm or less, 3600 ppm or less, 3700 ppm or less, 3800 ppm or less, 3900 ppm or less, or 4000 ppm or less, with respect to a total weight of the lithium composite transition metal oxide. When the tungsten (W) content is within the above range, batteries may exhibit improved output characteristics due to enhanced electrical conductivity.

According to an embodiment of the present invention, the coating layer may include at least one selected from an M'-O compound and a Li-M'-O compound, and M' may be at least one selected from Al and W. Specifically, when the coating layer is an M'-O compound, batteries may exhibit improved lifespan characteristics and output characteristics by suppressing degradation of the positive electrode surface and improving electrical conductivity.

According to an embodiment of the present invention, the coating layer may be of a film type, island type, or a combination of both. The film type may be of a continuous form, and the island type may be of a discontinuous form. When the coating layer satisfies the above-described form, batteries may exhibit improved lifespan characteristics and output characteristics by suppressing degradation of the positive electrode surface and improving electrical conductivity.

According to an embodiment of the present invention, the positive electrode active material may have an average particle size of 2.0 μm to 5.0 μm. Specifically, the positive electrode active material may have an average particle size of 2.0 μm or greater, 2.1 μm or greater, 2.2 μm or greater, 2.3 μm or greater, 2.4 μm or greater, 2.5 μm or greater, 2.6 μm or greater, 2.7 μm or greater, 2.8 μm or greater, 2.9 μm or greater, 3.0 μm or greater, 3.1 μm or greater, 3.2 μm or greater, 3.3 μm or greater, 3.4 μm or greater, 3.5 μm or greater, 3.6 μm or greater, 3.7 μm or greater, or 3.8 μm or greater, and an average particle size of 3.9 μm or less, 4.0 μm or less, 4.1 μm or less, 4.2 μm or less, 4.3 μm or less, 4.4 μm or less, 4.5 μm or less, 4.6 μm or less, 4.7 μm or less, 4.8 μm or less, 4.9 μm or less, or 5.0 μm or less. The coating layer formed on the lithium composite transition metal oxide according to the present invention is formed to have a nanometer-scale thickness, the difference in average particle size between the lithium transition metal oxide and the positive electrode active material may not be significant.

## Method for preparing positive electrode active material

Next, a method for preparing a positive electrode active material according to the present invention will be described. The method for preparing a positive electrode active material of the present invention is a method for preparing the positive electrode active material according to the present invention.

The method for preparing the positive electrode active material according to the present invention includes (A) mixing and firing a composite transition metal hydroxide and a lithium (Li)-containing raw material to prepare a lithium composite transition metal oxide, and (B) mixing the lithium composite transition metal oxide with an aluminum (Al)-containing raw material and a tungsten (W)-containing raw material to prepare a mixture, and then heat treating the mixture to form a coating layer including aluminum (Al) and tungsten (W) on the lithium composite transition metal oxide. The firing is performed at a temperature of 900 °C to 1000 °C.

The positive electrode active material according to the present invention described above may be prepared by appropriately regulating type of raw material, mixing ratio of raw materials, firing and heat treatment duration, and the like.

Hereinafter, the present invention will be described in detail for each step.

## Step A

The method for preparing the positive electrode active material according to the present invention includes step A of mixing and firing a composite transition metal hydroxide and a lithium (Li)-containing raw material to prepare a lithium composite transition metal oxide.

Specifically, the mixing may be performed by dry mixing or wet mixing. When mixing each component through dry mixing, the firing process may be performed without a separate drying process. In the case of mixing each component through wet mixing, the mixing is performed by adding a solvent, specifically water, or a mixture of water and an organic solvent (specifically alcohol or the like) that may be uniformly mixed with water, or preparing a solution containing each raw material, specifically an aqueous solution, and then mixing the solution, spray drying, and then firing the mixed components. Each raw material and composite transition metal hydroxide may be used in an appropriate amount, considering the content of each metal element in the lithium composite transition metal oxide to be finally prepared.

The composite transition metal hydroxide may be prepared by adding a composite transition metal aqueous solution, an ammonium cation complex forming agent, and a basic compound into a reactor and subjecting the mixture to a coprecipitation reaction.

The composite transition metal aqueous solution may be prepared by dissolving a transition metal-containing raw material in a solvent such as water and may be prepared, for example, by dissolving a nickel (Ni)-containing raw material, a cobalt (Co)-containing raw material, and a manganese (Mn)-containing raw material in water. That is, the composite transition metal-containing solution includes a nickel (Ni)-containing raw material, a cobalt (Co)-containing raw material, and a manganese (Mn)-containing raw material. In addition, when needed, the composite transition metal-containing solution may further include a metal-containing raw material containing a transition metal excluding nickel (Ni), cobalt (Co), and manganese (Mn) (e.g., at least one selected from Y, Zr, B, Al, W, Mg, Ce, Hf, Ta, La, Ti, Sr, Ba, Ce, F, P, S, and La).

The nickel (Ni)-containing raw material may be at least one selected from the group consisting of $NiO$, $Ni(OH)_2$, $NiO \cdot OH$, $NiCO_3 \cdot 2Ni(OH)_2 \cdot 4H_2O$, $NiC_2O_4 \cdot 2H_2O$, $Ni(NO_3)_2 \cdot 6H_2O$, fatty acid nickel, and nickel halides, and any one thereof or a mixture of two or more thereof may be used.

The cobalt (Co)-containing raw material may be at least one selected from the group consisting of $Co(OH)_2$, $Co_3O_4$, $CoO \cdot OH$, $Co(OCOCH_3)_2 \cdot 4H_2O$, $Co(NO_3)_2 \cdot 6H_2O$ or $Co(SO_4)_2 \cdot 7H_2O$, fatty acid cobalt, and cobalt halides, and any one thereof or a mixture of two or more thereof may be used.

The manganese (Mn)-containing raw material may be at least one selected from the group consisting of $MnCO_3$, $Mn_2O_3$, $MnO_2$, $Mn_3O_4$, $Mn(NO_3)_2$, manganese acetate, manganese dicarboxylate, manganese citrate, manganese salts of fatty acid manganese, oxyhydroxides, and halides of manganese chloride, and any one thereof or a mixture of two or more thereof may be used.

The nickel (Ni)-containing raw materials, the cobalt (Co)-containing raw materials, and the manganese (Mn)-containing raw materials may be used in appropriate amounts, considering the content of each metal element in the composite transition metal hydroxide being prepared.

Meanwhile, the ammonium cation complex forming agent may include at least one compound selected from the group consisting of $NH_4OH$, $(NH_4)_2SO_4$, $NH_4NO_3$, $NH_4Cl$, $CH_3COONH_4$, and $NH_4CO_3$, and may be put into a reactor in the form of a solution in which the compound is dissolved in a solvent. In this case, as the solvent, water, or a mixture of an organic solvent (specifically, alcohol or the like) that may be uniformly mixed with water and water may be used.

The basic compound may be at least one compound selected from the group consisting of $NaOH$, $KOH$, and $Ca(OH)_2$, and may be put into a reactor in the form of a solution in which the compound is dissolved in a solvent. In this case, as the solvent, water, or a mixture of an organic solvent (specifically, alcohol or the like) that may be uniformly mixed with water and water may be used.

As described above, when the composite transition metal aqueous solution, the ammonium cation complex forming agent, and the basic compound are put into a reactor, transition metals in the composite transition metal aqueous solution are co-precipitated to generate composite transition metal hydroxide-type precursor particles.

In this case, the basic compound may be added in an amount such that the pH of the reaction solution is within a desired range.

When the precursor particles are formed through the method described above, the particles are separated from the reaction solution to obtain a composite transition metal hydroxide. Specifically, the reaction solution may be filtered to separate the precursor particles from the reaction solution, and then the separated the precursor particles may be washed and dried to obtain a composite transition metal hydroxide. In this case, as needed, a process such as grinding and/or classification may be performed.

The composite transition metal hydroxide may have a composition represented by $Ni_pCo_qMn_rM^1_s(OH)_2$ (where $M^1$ is at least one selected from Y, Zr, B, Al, W, Mg, Ce, Hf, Ta, La, Ti, Sr, Ba, Ce, F, P, S, and La, and p, q, r, and s satisfy $0.5900 \leq p < 1.0000$, $0 < q < 0.4100$, $0 < r < 0.4100$, and $0 \leq s \leq 0.1000$).

The lithium (Li)-containing raw material may be at least one selected from the group consisting of LiOH, $Li_2CO_3$, $LiNO_3$, $LiNO_2$, $LiOH \cdot H_2O$, LiH, LiF, LiCl, LiBr, LiI, $CH_3COOLi$, $Li_2O$, Li acetate, Li dicarboxylic acid, Li citrate, Li fatty acid, alkyl lithium, and lithium halides, and any one thereof or a mixture of two or more thereof may be used. Specifically, LiOH or $Li_2CO_3$ may be used.

According to an embodiment of the present invention, in step A, the composite transition metal hydroxide and the lithium (Li)-containing raw material may be mixed in an amount to achieve a composition represented by Formula 1 above.

The firing is performed at a temperature of 900 °C to 1000 °C. Specifically, the firing is performed at a temperature of 900 °C or higher, 910 °C or higher, 920 °C or higher, 930 °C or higher, or 940 °C or higher, and at a temperature of 950 °C or lower, 960 °C or lower, 970 °C or lower, 980 °C or lower, 990 °C or lower, or 1000 °C or lower. When the firing temperature is within the above range, a lithium composite transition metal oxide in the form of a single particle may be formed. The lithium composite transition metal oxide, when is in the form of a single particle, has a small particle interface, which may prevent degradation caused by insulation at an interface or side reactions with an electrolyte due to particle breakage during rolling. Consequently, secondary batteries may have enhanced lifespan characteristics, particularly at high voltages. Meanwhile, when the firing is performed at a temperature lower than 900 °C, sufficient thermal energy is not supplied to form a lithium composite transition metal oxide in the form of a single particle, and when the firing is performed at a temperature higher than 1000 °C, overfiring takes place, resulting in the formation of a rock salt phase.

The firing may be performed for 6 hours to 20 hours. When the above range is satisfied, particles having high crystallinity and appropriate size may be obtained, and production efficiency may be improved.

The firing may be performed in an air atmosphere, an oxidizing atmosphere, or an inert atmosphere.

## Step B

The method for preparing the positive electrode active material according to the present invention includes step B of mixing the lithium composite transition metal oxide with an aluminum (Al)-containing raw material and a tungsten (W)-containing raw material to prepare a mixture, and then heat treating the mixture to form a coating layer including aluminum (Al) and tungsten (W) on the lithium composite transition metal oxide, after step A.

The mixing amount of the aluminum (Al)-containing raw material may be determined in consideration of the aluminum (Al) content in the mixture, and the mixing amount of the tungsten (W)-containing raw material may be determined in consideration of the tungsten (W) content in the mixture.

Specifically, the aluminum (Al)-containing raw material may be mixed to achieve the aluminum (Al) in an amount of 500 ppm to 5,000 ppm with respect to a total weight of the lithium composite transition metal oxide. That is, the aluminum (Al)-containing raw material may be mixed to achieve the aluminum (Al) in the mixture in an amount of 500 ppm to 5,000 ppm with respect to a total weight of the lithium composite transition metal oxide. In addition, the tungsten (W)-containing raw material may be mixed to achieve the tungsten (W) in an amount of 500 ppm or greater, and 4500 ppm or less, 5000 ppm or less, or 5500 ppm or less, with respect to a total weight of the lithium composite transition metal oxide. That is, the tungsten (W)-containing raw material may be mixed to achieve the tungsten (W) in the mixture in an amount of 500 ppm or greater, and 4500 ppm or less, or 5000 ppm or less, with respect to a total weight of the lithium composite transition metal oxide.

According to an embodiment of the present invention, the aluminum (Al)-containing raw material may be mixed to achieve the aluminum (Al) in an amount of 500 ppm to 4000 ppm with respect to a total weight of the lithium composite transition metal oxide. Specifically, the aluminum (Al)-containing raw material may be mixed to achieve the aluminum (Al) in an amount of 500 ppm or greater, 600 ppm or greater, 700 ppm or greater, 800 ppm or greater, 900 ppm or greater, or 1000 ppm or greater, and in an amount of 1500 ppm or less, 1600 ppm or less, 1700 ppm or less, 1800 ppm or less, 1900 ppm or less, 2000 ppm or less, 2100 ppm or less, 2200 ppm or less, 2300 ppm or less, 2400 ppm or less, 2500 ppm or less, 2600 ppm or less, 2700 ppm or less, 2800 ppm or less, 2900 ppm or less, 3000 ppm or less, 3100 ppm or less, 3200 ppm or less, 3300 ppm or less, 3400 ppm or less, 3500 ppm or less, 3600 ppm or less, 3700 ppm or less, 3800 ppm or less, 3900 ppm or less, or 4000 ppm or less, with respect to a total weight of the lithium composite transition metal oxide. When the mixing amount of the aluminum (Al)-containing raw material is within the above range, batteries may exhibit improved lifespan characteristics by removing hydrogen fluoride and suppressing degradation of the positive electrode surface due to side reactions between hydrogen fluoride and an electrolyte.

According to an embodiment of the present invention, the tungsten (W)-containing raw material may be mixed to achieve the tungsten (W) in an amount of 1000 ppm to 5500 ppm with respect to a total weight of the lithium composite transition metal oxide. Specifically, the tungsten (W)-containing raw material may be mixed to achieve the tungsten (W) in an amount of 1000 ppm or greater, 1100 ppm or greater, 1200 ppm or greater, 1300 ppm or greater, 1400 ppm or greater, 1500 ppm or greater, 1600 ppm or greater, 1700 ppm or greater, 1800 ppm or greater, 1900 ppm or greater, 2000 ppm or greater, 2100 ppm or greater, 2200 ppm or greater, 2300 ppm or greater, 2400 ppm or greater, or 2500 ppm or greater, and in an amount of 3000 ppm or less, 3100 ppm or less, 3200 ppm or less, 3300 ppm or less, 3400 ppm or less, 3500 ppm or less, 3600 ppm or less, 3700 ppm or less, 3800 ppm or less, 3900 ppm or less, 4000 ppm or less, 4100 ppm or less, 4200 ppm or less, 4300 ppm or less, 4400 ppm or less, 4500 ppm or less, 4600 ppm or less, 4700 ppm or less, 4800 ppm or less, 4900 ppm or less, 5000 ppm or less, 5100 ppm or less, 5200 ppm or less, 5300 ppm or less, 5400 ppm or less, or 5500 ppm or less, with respect to a total weight of the lithium composite transition metal oxide. When the mixing amount of the tungsten (W)-containing raw material is within the above range, batteries may exhibit improved output characteristics due to enhanced electrical conductivity.

According to an embodiment of the present invention, the aluminum (Al)-containing raw material may be at least one selected from oxide, carbonate, nitrate, hydroxide, oxyhydroxide, and halide, containing aluminum (Al), and the tungsten (W)-containing raw material may be at least one selected from oxide, carbonate, nitrate, hydroxide, oxyhydroxide, and halide, containing tungsten (W). Considering economic efficiency and process convenience, specifically, $Al_2O_3$ and $WO_3$ may be used.

According to an embodiment of the present invention, the firing may be performed at a temperature of 300 °C to 600 °C. Specifically, the firing may be performed at a temperature of 300 °C or higher, 350 °C or higher, 400 °C or higher, 450 °C or higher, or 500 °C or higher, and at a temperature of 550 °C or lower, or 600 °C or lower. When the heat treatment temperature is within the above range, the heat energy required for coating may be sufficiently supplied. When the lithium composite transition metal oxide and the aluminum (Al)-containing raw material and the tungsten (W)-containing raw material are mixed and then heat treated within the above temperature range, a coating layer containing aluminum (Al) and tungsten (W) may be formed on the lithium composite transition metal oxide. The coating layer may include at least one selected from an Al-O compound, a W-O compound, an Al-W-O compound, a Li-Al-O compound, a Li-W-O compound, and a Li-Al-W-O compound. In addition, the coating layer containing aluminum (Al) and tungsten (W) may partially cover (discontinuously) at least a portion of the lithium composite transition metal oxide, i.e., a region of the lithium composite transition metal oxide, or may cover (continuously) an entire region. The coating layer may be of a film type, island type, or a combination of both.

The heat treatment may be performed in an air atmosphere, an oxidizing atmosphere, or an inert atmosphere.

The heat treatment may be performed for 2 hours to 10 hours. When the heat treatment duration is within the above range, the heat energy required for coating may be sufficiently supplied.

## Positive electrode

Next, a positive electrode according to the present invention will be described.

The positive electrode according to the present invention includes a positive electrode active material layer including the positive electrode active material according to the present invention. Specifically, the positive electrode includes a positive electrode current collector, and a positive electrode active material layer provided on the positive electrode current collector and including the positive electrode active material. Since the positive electrode active material has been described above, the detailed description thereof will be skipped, and hereinafter, the other components will only be described.

The positive electrode current collector is not particularly limited as long as it has conductivity without causing chemical changes in batteries. For example, stainless steel, aluminum, nickel, titanium, fired carbon, or aluminum or stainless steel that is surface-treated with one of carbon, nickel, titanium, silver, and the like may be used. In addition, the positive electrode current collector may typically have a thickness of 3 $\mu$m to 500 $\mu$m, and fine irregularities may be formed on a surface of the current collector to improve the adhesion of a positive electrode active material. For example, the positive electrode current collector may be used in various forms such as a film, a sheet, a foil, a net, a porous body, a foam body, and a non-woven fabric body.

The positive electrode active material layer may include a conductive material and a binder, together with a positive electrode active material. In this case, the positive electrode active material may be included in an amount of 80 wt% to 99 wt%, for example, 85 wt% to 98.5 wt% with respect to a total weight of the positive electrode active material layer, and excellent capacity properties may be obtained within this range.

The conductive material is used to impart conductivity to an electrode, and any conductive material may be used without particular limitation as long as it has electron conductivity without causing chemical changes in batteries to be constituted. Specific examples thereof may include graphite such as natural graphite or artificial graphite; a carbon-based material such as carbon black, acetylene black, Ketjen black, channel black, furnace black, lamp black, thermal black, and carbon fiber; metal powder or metal fiber such as copper, nickel, aluminum, and silver; a conductive whisker such as a zinc oxide whisker and a potassium titanate whisker; a conductive metal oxide such as a titanium oxide; or a conductive polymer such as a polyphenylene derivative, and any one thereof or a mixture of two or more thereof may be used. The conductive material may be included in an amount of 0.1 wt% to 15 wt% with respect to the total weight of the positive electrode active material layer.

The binder serves to improve the bonding between positive electrode active material particles and the adhesion between the positive electrode active material and the current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene polymer (EPDM), a sulfonated EPDM, styrene-butadiene rubber (SBR), fluorine rubber, or various copolymers thereof, and any one thereof or a mixture of two or more thereof may be used. The binder may be included in an amount of 0.1 wt% to 15 wt% with respect to the total weight of the positive electrode active material layer.

The positive electrode may be prepared according to a typical method of preparing a positive electrode, except that the positive electrode active material described above is used. Specifically, a composition for forming a positive electrode active material layer, which is prepared by dissolving or dispersing the positive electrode active material and optionally, a binder and a conductive material in a solvent, may be applied onto the positive electrode current collector, and then dried and rolled to prepare the positive electrode. In this case, types and amounts of the positive electrode active material, the binder, and the conductive material are as described above. In addition, in another method, the positive electrode may be prepared by casting a composition for forming the positive electrode material layer on a separate support and then laminating a film separated from the support on the positive electrode current collector.

The solvent may be a solvent commonly used in the art, and may be dimethyl sulfoxide (DMSO), isopropyl alcohol, N-methylpyrrolidone (NMP), acetone, water, or the like, and any one thereof or a mixture of two or more thereof may be used. An amount of the solvent used may be sufficient if the solvent may dissolve or disperse the positive electrode active material, the conductive material, and the binder in consideration of an applying thickness of the slurry and preparation yield, and thereafter, have a viscosity which may exhibit excellent thickness uniformity upon application for the preparation of the positive electrode.

## Lithium secondary battery

Next, a lithium secondary battery according to the present invention will be described.

The present invention may manufacture an electrochemical device including the positive electrode. The electrochemical device may be specifically a battery, a capacitor, or the like, and more specifically, may be a lithium secondary battery.

Specifically, the lithium secondary battery includes a positive electrode, a negative electrode positioned to face the positive electrode, a separator interposed between the positive electrode and the negative electrode, and an electrolyte. The positive electrode is the same as described above, and thus, a detailed description thereof will be skipped, and hereinafter, the other components will only be described.

In addition, the lithium secondary battery may further optionally include a battery container accommodating an electrode assembly of the positive electrode, the negative electrode, and the separator, and a sealing member sealing the battery container.

In the lithium secondary battery, the negative electrode includes a negative electrode current collector and a negative electrode active material layer positioned on the negative electrode current collector.

The negative electrode current collector is not particularly limited as long as it has a high conductivity without causing chemical changes in batteries. For example, copper, stainless steel, aluminum, nickel, titanium, fired carbon, copper or stainless steel that is surface-treated with one of carbon, nickel, titanium, silver, and the like, an aluminum-cadmium alloy, and the like may be used. In addition, the negative electrode current collector may typically have a thickness of 3 $\mu$m to 500 $\mu$m, and as in the case of the positive electrode current collector, fine irregularities may be formed on the surface of the current collector to improve the adhesion of a negative electrode active material. For example, the negative electrode current collector may be used in various forms such as a film, a sheet, a foil, a net, a porous body, a foam body, and a non-woven fabric body.

The negative electrode active material layer optionally includes a binder and a conductive material in addition to the negative electrode active material.

A compound capable of reversibly intercalating and deintercalating lithium may be used as the negative electrode active material. Specific examples thereof may include a carbonaceous material such as artificial graphite, natural graphite, graphitized carbon fiber, and amorphous carbon; a metallic compound alloyable with lithium such as Si, Al, Sn, Pb, Zn, Bi, In, Mg, Ga, Cd, an Si alloy, an Sn alloy, or an Al alloy; a metal oxide which may be doped and undoped with lithium such as $SiO_\beta$ ($0<\beta<2$), $SnO_2$, a vanadium oxide, and a lithium vanadium oxide; or a composite including the metallic compound and the carbonaceous material such as an Si-C composite or an Sn-C composite, and any one thereof or a mixture of two or more thereof may be used. In addition, a metallic lithium thin film may be used as the negative electrode active material. In addition, as the carbon material, both low crystalline carbon and high crystalline carbon may be used. Typical examples of the low crystalline carbon may be soft carbon and hard carbon, and typical examples of the high crystalline carbon may be irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature fired carbon such as petroleum or coal tar pitch derived cokes.

The negative electrode active material may be included in an amount of 80 wt% to 99 wt% with respect to the total weight of a negative electrode active material layer.

The binder is a component for assisting in bonding between a conductive material, an active material, and a current collector, and is typically added in an amount of 0.1 wt% to 10 wt% with respect to the total weight of a negative electrode active material layer. Examples of the binder may include polyvinylidene fluoride (PVDF), polyvinyl alcohol, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene monomer (EPDM), a sulfonated EPDM, styrene-butadiene rubber, nitrile-butadiene rubber, fluorine rubber, various copolymers thereof, and the like.

The conductive material is a component for further improving the conductivity of a negative electrode active material, and may be added in an amount of 10 wt% or less, specifically 5 wt% or less, with respect to the total weight of a negative electrode active material layer. The conductive material is not particularly limited as long as it has conductivity without causing chemical changes in batteries, and, for example, a conductive material, such as: graphite such as natural graphite or artificial graphite; carbon black such as acetylene black, Ketjen black, channel black, furnace black, lamp black, and thermal black; conductive fibers such as carbon fibers or metal fibers; fluorocarbon; metal powder such as aluminum powder and nickel powder; conductive whiskers such as zinc oxide whiskers and potassium titanate whiskers; conductive metal oxide such as titanium oxide; or polyphenylene derivatives, may be used.

The negative electrode active material layer may be prepared by applying a composition for forming a negative electrode active material layer, which is prepared by dissolving or dispersing a negative electrode active material and optionally a binder and a conductive material in a solvent, on a negative electrode collector, followed by drying, or may be prepared by casting a composition for forming a negative electrode active material layer on a separate support and then laminating a film separated from the support on the negative electrode collector.

Meanwhile, in the lithium secondary battery, a separator is to separate the negative electrode and the positive electrode and to provide a movement path for lithium ions. Any separator may be used without particular limitation as long as it is typically used as a separator in a lithium secondary battery. Particularly, a separator having high moisture-retention ability for an electrolyte as well as low resistance to the movement of electrolyte ions is preferable. Specifically, a porous polymer film, for example, a porous polymer film prepared using a polyolefin-based polymer such as an ethylene homopolymer, a propylene homopolymer, an ethylene/butene copolymer, an ethylene/hexene copolymer, and an ethylene/methacrylate copolymer, or a laminated structure having two or more layers thereof may be used. In addition, a typical porous nonwoven fabric, for example, a nonwoven fabric formed of glass fiber having a high melting point or polyethylene terephthalate fiber may be used. Furthermore, a coated separator including a ceramic component or a polymer material may be used to secure heat resistance or mechanical strength, and a separator having a single-layer structure or a multi-layer structure may be optionally used.

In addition, the electrolyte used in the present invention may be an organic liquid electrolyte, an inorganic liquid electrolyte, a solid polymer electrolyte, a gel-type polymer electrolyte, a solid inorganic electrolyte, a molten-type inorganic electrolyte, and the like, all of which may be used in the manufacture of a lithium secondary battery, but is not limited thereto.

Specifically, the electrolyte may include an organic solvent and a lithium salt.

Any organic solvent may be used without particular limitation as long as it may serve as a medium through which ions involved in an electrochemical reaction of a battery may move. Specifically, as the organic solvent, an ester-based solvent such as methyl acetate, ethyl acetate, $\gamma$-butyrolactone, and $\varepsilon$-caprolactone; an ether-based solvent such as dibutyl ether or tetrahydrofuran; a ketone-based solvent such as cyclohexanone; an aromatic hydrocarbon-based solvent such as benzene and fluorobenzene; a carbonate-based solvent such as dimethyl carbonate (DMC), diethyl carbonate (DEC), ethylmethyl carbonate (EMC), ethylene carbonate (EC), and propylene carbonate (PC); an alcohol-based solvent such as ethyl alcohol and isopropyl alcohol; nitriles such as R-CN (where R is a linear, branched, or cyclic C2 to C20 hydrocarbon group and may include a double-bond aromatic ring or ether bond); amides such as dimethylformamide; dioxolanes such as 1,3-dioxolane; or sulfolanes may be used. Among these solvents, a carbonate-based solvent is preferable, and a mixture of a cyclic carbonate (e.g., ethylene carbonate or propylene carbonate) having a high ionic conductivity and a high dielectric constant and a linear carbonate-based compound having a low viscosity (e.g., ethylmethyl carbonate, dimethyl carbonate, or diethyl carbonate), the mixture which may increase charging/discharging performance of a battery, is more preferable. In this case, the electrolyte may exhibit excellent performance when the cyclic carbonate and the chain carbonate are mixed in a volume ratio of about 1:1 to about 1:9.

Any compound may be used as the lithium salt without particular limitation as long as it may provide lithium ions used in a lithium secondary battery. Specifically, as the lithium salt, $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$. LiCl, LiI, $LiB(C_2O_4)_2$, or the like may be used. The lithium salt may be used in a concentration range of 0.1 M to 5.0 M, specifically 0.1 M to 3.0 M. When the concentration of the lithium salt is included within the above range, the electrolyte has suitable conductivity and viscosity and may thus exhibit excellent performance, and lithium ions may effectively move.

In the electrolyte, in order to improve the lifespan characteristics of a battery, suppress the decrease in battery capacity, and improve the discharge capacity of a battery, at least one additive, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride may be further included. In this case, the additive may be included in an amount of 0.1 wt% to 10 wt%, specifically 0.1 wt% to 5 wt%, with respect to a total weight of the electrolyte.

The lithium secondary battery including the positive electrode active material according to the present invention as describe above exhibits superior lifespan characteristics, rate characteristics, and capacity characteristics, and thus, are useful for portable devices such as a mobile phone, a notebook computer, and a digital camera, and in the field of electric cars such as a hybrid electric vehicle (HEV).

Thus, according to another embodiment of the present invention, a battery module including the lithium secondary battery as a unit cell, and a battery pack including the same are provided.

The battery module or the battery pack may be used as a power source of at least any one medium and large sized device of a power tool; electric cars including an electric vehicle (EV), a hybrid electric vehicle, and a plug-in hybrid electric vehicle (PHEV); or a power storage system.

An outer shape of the lithium secondary battery of the present invention is not particularly limited, but a cylindrical type using a can, a prismatic type, a pouch type, or a coin type may be used.

The lithium secondary battery according to the present invention may be used in a battery cell which is used as a power source for a small-sized device, and may also be preferably used as a unit cell for a medium- and large-sized battery module including a plurality of battery cells.

Hereinafter, Examples of the present invention will be described in detail in such a manner that it may easily be performed by a person skilled in the art to which the present invention pertains. The present invention may, however, be embodied in many different forms, and is not limited to examples set forth herein.

MODE FOR CARRYING OUT THE INVENTION

**Examples and Comparative Examples**

**Example 1**

A composite transition metal hydroxide having a composition represented by $Ni_{0.60}Co_{0.05}Mn_{0.35}(OH)_2$ (product name: nickel cobalt manganese hydroxide, $D_{50}$: 3.5 $\mu$m$\pm$0.2 $\mu$m, secondary particle) and $Li_2CO_3$ were added to achieve a molar ratio of (Ni+Co+Mn):Li of 1:1.05, and $Y_2O_3$ and $ZrO_2$ were added to achieve Y and Zr in an amount of 1,500 ppm and 3,000 ppm, respectively, with respect to a total weight of $Ni_{0.60}Co_{0.05}Mn_{0.35}(OH)_2$ to prepare a mixture. The mixture was fired at 950 °C for 14 hours in an air atmosphere to prepare a lithium composite transition metal oxide in the form of a single particle and having a composition represented by $Li_{1.029}Ni_{0.5995}Co_{0.0498}Mn_{0.3465}Zr_{0.0013}Y_{0.0029}O_2$.

The lithium composite transition metal oxide $Li_{1.029}Ni_{0.5995}Co_{0.0498}Mn_{0.3465}Zr_{0.0013}Y_{0.0029}O_2$, $Al_2O_3$, and $WO_3$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 3000 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

### Example 2

The lithium composite transition metal oxide $Li_{1.029}Ni_{0.5995}Co_{0.0498}Mn_{0.3465}Zr_{0.0013}Y_{0.0029}O_2$ prepared in Example 1, $Al_2O_3$, and $WO_3$ were mixed to prepare a mixture. In this case, the $Al_2O_3$ was mixed to achieve aluminum (Al) in an amount of 1000 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 3000 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

### Example 3

The lithium composite transition metal oxide $Li_{1.029}Ni_{0.5995}Co_{0.0498}Mn_{0.3465}Zr_{0.0013}Y_{0.0029}O_2$ prepared in Example 1, $Al_2O_3$, and $WO_3$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 2500 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

### Example 4

The lithium composite transition metal oxide $Li_{1.029}Ni_{0.5995}Co_{0.0498}Mn_{0.3465}Zr_{0.0013}Y_{0.0029}O_2$ prepared in Example 1, $Al_2O_3$, and $WO_3$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 1500 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

### Example 5

The lithium composite transition metal oxide $Li_{1.029}Ni_{0.5995}Co_{0.0498}Mn_{0.3465}Zr_{0.0013}Y_{0.0029}O_2$ prepared in Example 1, $Al_2O_3$, and $WO_3$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 4300 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

### Example 6

The lithium composite transition metal oxide $Li_{1.029}Ni_{0.5995}Co_{0.0498}Mn_{0.3465}Zr_{0.0013}Y_{0.0029}O_2$ prepared in Example 1, $Al_2O_3$, and $WO_3$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 500 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

**Example 7**

The lithium composite transition metal oxide $Li_{1.029}Ni_{0.5995}Co_{0.0498}Mn_{0.3465}Zr_{0.0013}Y_{0.0029}O_2$ prepared in Example 1, $Al_2O_3$, and $WO_3$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 5000 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

**Comparative Example 1**

A composite transition metal hydroxide having a composition represented by $Ni_{0.60}Co_{0.05}Mn_{0.35}(OH)_2$ (product name: nickel cobalt manganese hydroxide, $D_{50}$: 3.5 μm±0.2 μm, secondary particle) and $Li_2CO_3$ were added to achieve a molar ratio of (Ni+Co+Mn):Li of 1:1.05, and $Y_2O_3$ and $ZrO_2$ were added to achieve Y and Zr in an amount of 1,500 ppm and 3,000 ppm, respectively, with respect to a total weight of $Ni_{0.60}Co_{0.05}Mn_{0.35}(OH)_2$ to prepare a mixture. The mixture was fired at 800 °C for 10 hours in an air atmosphere to prepare a lithium composite transition metal oxide in the form of a secondary particle and having a composition represented by $Li_{1.029}Ni_{0.5995}Co_{0.0498}Mn_{0.3465}Zr_{0.0013}Y_{0.0029}O_2$.

The lithium composite transition metal oxide $Li_{1.029}Ni_{0.5995}Co_{0.0498}Mn_{0.3465}Zr_{0.0013}Y_{0.0029}O_2$, $Al_2O_3$, and $WO_3$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 3000 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) and tungsten (W) on the lithium composite transition metal oxide. The coating layer includes an Al-O compound, a W-O compound, an Al-W-O compound, a Li-Al-O compound, a Li-W-O compound, and a Li-Al-W-O compound, and is of a film type, an island type, or a combination thereof.

**Comparative Example 2**

The lithium composite transition metal oxide $Li_{1.029}Ni_{0.5995}Co_{0.0498}Mn_{0.3465}Zr_{0.0013}Y_{0.0029}O_2$ prepared in Example 1 and $Al_2O_3$ were mixed to prepare a mixture. In this case, the $Al_2O_3$ was mixed to achieve the aluminum (Al) in an amount of 1500 ppm with respect to a total weight of $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing aluminum (Al) on the lithium composite transition metal oxide. The coating layer includes an Al-O compound and a Li-Al-O compound, and is of a film type, an island type, or a combination thereof.

**Comparative Example 3**

The lithium composite transition metal oxide $Li_{1.029}Ni_{0.5995}Co_{0.0498}Mn_{0.3465}Zr_{0.0013}Y_{0.0029}O_2$ prepared in Example 1, $H_3BO_4$, and $WO_3$ were mixed to prepare a mixture. In this case, the $B_2O_3$ was mixed to achieve boron (B) in an amount of 700 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve tungsten (W) in an amount of 3000 ppm with respect to a total weight of the $Li_{1.029}Ni_{0.5995}Co_{0.0498}Mn_{0.3465}Zr_{0.0013}Y_{0.0029}O_2$.

The mixture was heat treated for 6 hours in an air atmosphere at a temperature of 500 °C to prepare a positive electrode active material including a coating layer containing boron (B) and tungsten (W) on the lithium composite transition metal oxide. The coating layer includes a B-O compound, a W-O compound, a B-W-O compound, a Li-B-O compound, a Li-W-O compound, and a Li-B-W-O compound, and is of a film type, an island type, or a combination thereof.

**Comparative Example 4**

The lithium composite transition metal oxide of Example 1 was used as a positive electrode active material of Comparative Example 4.

**Comparative Example 5**

A positive electrode active material was prepared in the same manner as in Comparative Example 2, except that $Al_2O_3$ was mixed to achieve aluminum (Al) in an amount of 5000 ppm with respect to a total weight of $Li_{1.029}Ni_{0.5995}Co_{0.0498}Mn_{0.3465}Zr_{0.0013}Y_{0.0029}O_2$.

**Comparative Example 6**

The lithium composite transition metal oxide $Li_{1.029}Ni_{0.5995}Co_{0.0498}Mn_{0.3465}Zr_{0.0013}Y_{0.0029}O_2$ prepared in Example 1, $Al_2O_3$, and $H_3BO_4$ were mixed to prepare a mixture. In this case, the $Al_2O_3$ was mixed to achieve aluminum (Al) in an amount of 1500 ppm with respect to a total weight of the $Li_{1.029}Ni_{0.5995}Co_{0.0498}Mn_{0.3465}Zr_{0.0013}Y_{0.0029}O_2$, and the $WO_3$ was mixed to achieve boron (B) in an amount of 700 ppm with respect to a total weight of the $Li_{1.029}Ni_{0.5995}Co_{0.0498}Mn_{0.3465}Zr_{0.0013}Y_{0.0029}O_2$. The mixture was heat treated for 6 hours in an air atmosphere at a temperature of 500 °C to prepare a positive electrode active material including a coating layer containing aluminum (Al) and boron (B) on the lithium composite transition metal oxide. The coating layer includes an Al-O compound, a B-O compound, an Al-B-O compound, a Li-Al-O compound, a Li-B-O compound, and a Li-Al-B-O compound, and is of a film type, an island type, or a combination thereof.

**Experimental Examples**

**Experimental Example 1: Analysis of lithium composite transition metal oxide**

**- Shape of lithium composite transition metal oxide**

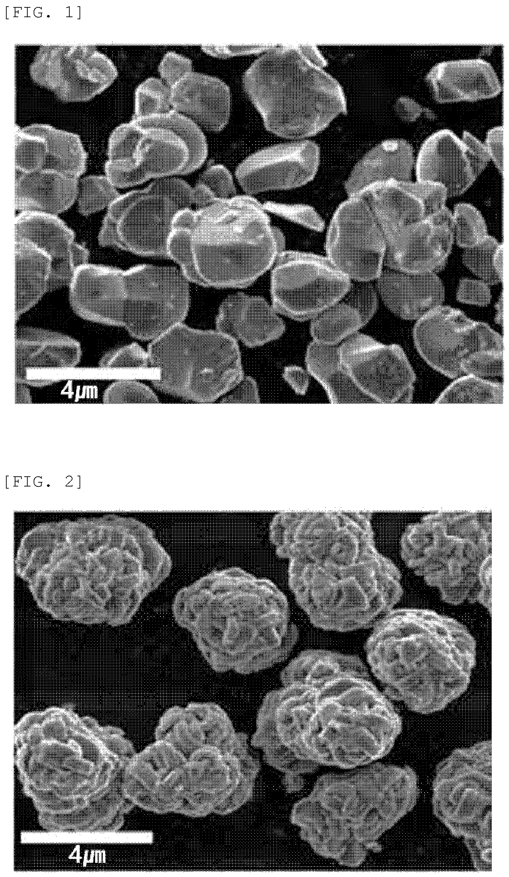

For the lithium composite transition metal oxides prepared in Example 1 and Comparative Example 1, SEM images were obtained using a scanning electron microscope (SEM), and these images are shown in FIGS 1 to 2.
FIG. 1 is an SEM image showing a positive electrode active material prepared in Example 1.
FIG. 2 is an SEM image showing a positive electrode active material prepared in Comparative Example 1.
As shown in FIGS. 1 to 2, the lithium composite transition metal oxide prepared in Example 1 according to the present invention was found to be in the form of a single particle. In addition, the lithium composite transition metal oxide prepared in Example 1 was found to be composed of fewer primary particles compared to the lithium composite transition metal oxide in the form of a secondary particle prepared in Comparative Example 1.

**- Composition of lithium composite transition metal oxide**

For the lithium composite transition metal oxide prepared in Example 1 above, the composition of the lithium composite transition metal oxide is determined through the following method, and is shown in Table 1 below.
1 ml of hydrochloric acid was added to 0.1 g of each of the lithium composite transition metal oxide particles prepared in Examples 1, and the mixture was heated to dissolve the lithium composite transition metal oxide. Thereafter, a small amount of hydrogen peroxide was added to promote a reaction, and the lithium composite transition metal oxide was completely dissolved to prepare a solution. Then, the solution was diluted to a total volume of 10 mL with deionized water to prepare an analysis sample. Using ICP-OES (Aligent5100, Aligent), the composition of the lithium composite transition metal oxide present in the above analysis sample was determined, and is shown in Table 1 below.

[Table 1]

|  | Composition |
|---|---|
| Example 1 | $Li_{1.029}Ni_{0.5995}Co_{0.0498}Mn_{0.3465}Y_{0.0013}Zr_{0.0029}O_2$ |

Table 1 shows that the lithium composite transition metal oxide prepared in Example 1 had a Ni content of 59 mol% to 70 mol% among all metals excluding lithium, and had a composition represented by Formula 1 described herein.

**-Particle size and single particle formation degree of lithium composite transition metal oxides**

Using PSA (S3500, Microtrac), an average particle size ($D_{50}$) of the lithium composite transition metal oxide prepared in Example 1 was measured, and is shown in Table 2 below.
In addition, using SEM (FEI, Inspect F), an SEM image (magnification: 5 K) of the lithium composite transition metal oxide prepared in Example 1 was obtained, and using an image processing program (LG Chemical, DX program), an image where primary particles present in the SEM image were segmented and colored randomly was obtained. Using the images where primary particles were segmented and colored randomly, an area of each primary particle was calculated based on the number of pixels corresponding to each of the n primary particles (on average, at least 50,000 primary particles) and an average particle size ($D'_{50}$) of primary particles present in the lithium composite transition metal oxide prepared in Example 1 was measured using the radius of a circle having the same area as each primary particle, and the results are shown in Table 2 below. In addition, a value of the average particle size ($D'_{50}$) of the primary particles to the average particle size ($D_{50}$) of the lithium composite transition metal oxide (single particle formation degree ($\chi$)) was calculated and shown in Table 2 below.

[Table 2]

| Item | Average particle size ($\mu$m) | | Single particle formation degree ($\chi$) |
| --- | --- | --- | --- |
| | Primary particle ($D'_{50}$) | Lithium composite transition metal oxide ($D_{50}$) | |
| Example 1 | 2.2 | 3.8 | 0.60 |

Table 2 shows that the positive electrode active material including a coating layer containing aluminum (Al) and tungsten (W), i.e., a lithium composite transition metal oxide prepared in Example 1, had an average particle size ($D'_{50}$) of primary particles of 1.0 $\mu$m to 3.5 $\mu$m, an average particle size ($D_{50}$) of the lithium composite transition metal oxide of 2.0 $\mu$m to 5.0 $\mu$m, and a single particle formation degree ($\chi$) of 0.55 to 0.65 according to Equation 1 described herein.

**- Analysis of average crystallite size**

Each lithium composite transition metal oxide prepared in Examples 1 to 3 and Comparative Example 1 was subjected to XRD measurement, and then average crystallite size (nm) is shown in Table 3 below.

In this case, the XRD measurement was conducted using D8 Endeavor from Bruker, and 2 g to 3 g of positive electrode active material particles were collected from each positive electrode active material powder, and measured at a scan speed of 0.2 °/sec in a range of 2$\theta$ 15 ° to 80 ° under the following conditions: Cu-K$\alpha$ line (wavelength: 1.54 Å), acceleration voltage of 40 kV, and current of 40 mA.

[Table 3]

| Item | Average crystallite size (nm) |
| --- | --- |
| Example 1 | 184 |
| Example 2 | 190 |
| Example 3 | 184 |
| Comparative Example 1 | 118 |

Table 3 shows that the lithium composite transition metal oxides prepared in Examples 1 to 3 had an average crystallite size of 120 nm to 200 nm.

**Experimental Example 2: Analysis of coating layer**

**- Content of aluminum (Al) and tungsten (W)**

Inductively coupled plasma-mass spectrometer (ICP-MS) analysis was performed, and the content of aluminum (Al), tungsten (W), and boron (B) included in the coating layer of the positive electrode active materials prepared in Examples 1 to 7 and Comparative Examples 1 to 6 was measured, and the results are shown in Table 4 below.

[Table 4]

| Item | Content (ppm) | | |
| --- | --- | --- | --- |
| | Aluminum (Al) | Tungsten (W) | Boron (B) |
| Example 1 | 1,305 | 2,212 | - |

(continued)

| Item | Content (ppm) | | |
|---|---|---|---|
| | Aluminum (Al) | Tungsten (W) | Boron (B) |
| Example 2 | 1,034 | 2,370 | - |
| Example 3 | 1,320 | 2,010 | - |
| Example 4 | 1,300 | 1,230 | - |
| Example 5 | 1,240 | 3,850 | - |
| Example 6 | 1,110 | 320 | - |
| Example 7 | 1,300 | 4,250 | - |
| Comparative Example 1 | 1,384 | 2,240 | - |
| Comparative Example 2 | 1,390 | - | - |
| Comparative Example 3 | - | 2,444 | 599 |
| Comparative Example 4 | - | - | - |
| Comparative Example 5 | 4,120 | - | - |
| Comparative Example 6 | 1,220 | - | 540 |

As shown in Table 4, it is determined that the positive electrode active materials prepared in Examples 1 to 7 had a coating layer containing aluminum (Al) and tungsten (W). In addition, it is determined that the content of aluminum (Al) included in the coating layer of the positive electrode active materials prepared in Examples 1 to 5 was 500 ppm to 4,000 ppm with respect to the total weight of the lithium composite transition metal oxide, and it is determined that the content of tungsten (W) included in the coating layer was 1,000 ppm to 4,000 ppm with respect to the total weight of the lithium composite transition metal oxide.

Meanwhile, it is determined that the positive electrode active materials prepared in Comparative Examples 2 to 6 contained no aluminum (Al) and/or tungsten (W) in the coating layer.

**- Shape of coating layer**

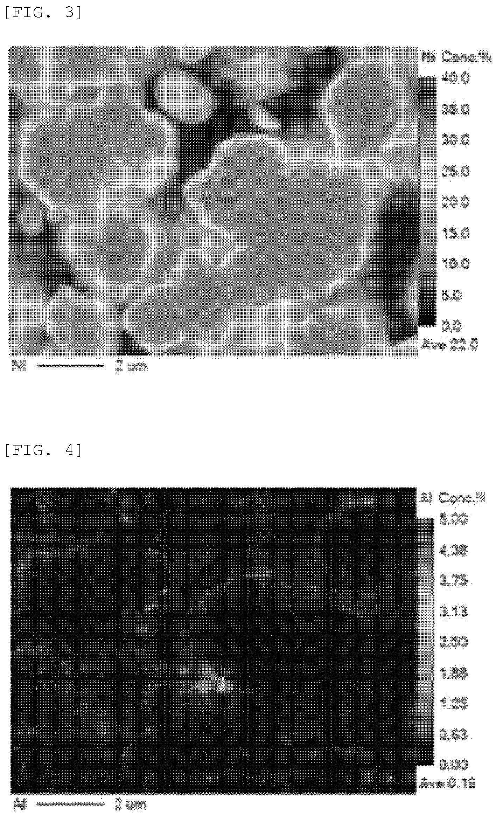

EPMA mapping images of the positive electrode active material prepared in Example 1 are shown in FIGS. 3 to 5 below.

Specifically, EPMA is a technique for determining the concentration and distribution of elements in solid samples through analysis of emitted X-rays by EDS after bombardment of sample particles via electron beam. Using EPMA (JEOL JXA-iHP200F, 15 kV, 20 nA mapping conditions) for the positive electrode active material prepared in Example 1, the distribution of each of nickel, aluminum, and tungsten in the positive electrode active material was shown.

FIG. 3 is an EPMA nickel element mapping image for a positive electrode active material prepared in Example 1.

FIG. 4 is an EPMA aluminum element mapping image for a positive electrode active material prepared in Example 1.

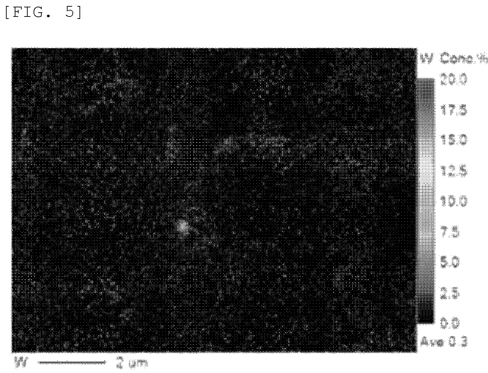

FIG. 5 is an EPMA tungsten element mapping image for a positive electrode active material prepared in Example 1.

As shown in FIGS. 3 to 5, it is determined that the positive electrode active material prepared in Example 1 according to the present invention had a coating layer (blue part) containing aluminum along the adjacent boundary between particles, and a coating layer (light green part) containing tungsten formed evenly over an entire surface. In conclusion, it is determined that the coating layer was a film type, an island type, or a combination thereof.

**Experimental Example 3: Analysis of positive electrode active material**

**-Particle size of positive electrode active material**

Using PSA (S3500, Microtrac), an average particle size of the positive electrode active material prepared in Example 1 was measured, and is shown in Table 5 below.

[Table 5]

|  | Average particle size ($\mu$m) |
| --- | --- |
| Example 1 | 3.8 |
| Comparative Example 1 | 3.6 |

As shown in Table 5, it is determined that the positive electrode active material prepared in Example 1 had an average particle size of 2.0 $\mu$m to 5.0 $\mu$m. Meanwhile, it is seen that the coating layer was formed to have a nanometer-scale thickness based on the fact that the average particle size of the positive electrode active material prepared in Example 1 including a coating layer and the average particle size of the lithium composite transition metal oxide prepared in Example 1 not including a coating layer were almost the same.

**Experimental Example 4: Evaluation of battery properties**

**- Manufacturing of coin type half-cells**

A positive electrode slurry was prepared by mixing 97.5 wt% of each of the positive electrode active materials prepared in Examples 1 to 3 and Comparative Examples 1 to 6, 1.0 wt% of Super P as a conductive material, and 1.5 wt% of polyvinylidene fluoride (PVDF) as a binder in an N-methylpyrrolidone (NMP) solvent. The prepared positive electrode slurry was applied onto one surface of an aluminum current collector, dried at 130 °C, and then rolled to prepare a positive electrode.

A lithium metal electrode was used as a negative electrode, and an electrode assembly was prepared by disposing a porous polyethylene separator between the positive electrode and the negative electrode. The electrode assembly was placed inside a battery case and an electrolyte where 1 M $LiPF_6$ was dissolved in an organic solvent in which ethylene carbonate (EC), ethyl methyl carbonate (EMC), and diethyl carbonate (DEC) were mixed in a volume ratio of 3:4:3 was injected to manufacture a coin-type half-cell.

**- Evaluation of battery properties**

Using the coin type half-cells containing each of the positive electrode active materials prepared in Example 1 and Comparative Example 1, the cells were charged (0.1 C) up to 4.3 V in CC-CV mode at 25 °C , and then discharged (0.1 C) up to 2.5 V in CC mode to perform a charge/discharge process, and the charge and discharge capacities in this case were measured. The measured charge and discharge capacities and the percentage of discharge capacity to charge capacity (efficiency (%)) are shown in Table 6 below.

Using the coin type half-cells containing each of the positive electrode active materials prepared in Example 1 and Comparative Example 1, a cycle in which the cells were charged (0.33 C) up to 4.3 V in CC-CV mode at 45 °C, and then discharged (0.33 C) up to 2.5 V in CC mode was considered one cycle, and a total of 30 cycles of charging and discharging were repeated, and the discharge capacity at the first cycle and at the 30th cycle was measured, and the measured discharge capacity at the first cycle and at the 30th cycle and a percentage of the discharge capacity at the 30th cycle to the discharge capacity at the first cycle (capacity retention (%)) are shown in Table 6 below.

Using the coin type half-cells containing each of the positive electrode active materials prepared in Examples 1 to 7 and Comparative Examples 2 to 6, the cells were charged (0.1 C) up to 4.45 V in CC-CV mode at 25 °C , and then discharged (0.1 C) up to 2.5 V in CC mode to perform a charge/discharge process, and the charge and discharge capacities in this case were measured. The measured charge and discharge capacities and the percentage of discharge capacity to charge capacity (efficiency (%)) are shown in Table 7 below.

Using the coin type half-cells containing each of the positive electrode active materials prepared in Examples 1 to 7 and Comparative Examples 2 to 6, the cells were charged (0.5 C) up to 4.45 V in CC-CV mode at 25 °C , and then discharged (2 C) up to 2.5 V in CC mode to perform a charge/discharge process, and the charge and discharge capacities in this case were measured. The measured discharge capacities are shown in Table 6 below. In addition, the percentage of the 2 C discharge capacity to the 0.1 C discharge capacity at 25 °C (2 C/0.1 C (%)) is shown in Table 7 below.

Using the coin type half-cells containing each of the positive electrode active materials prepared in Examples 1 to 7 and Comparative Examples 2 to 6, a cycle in which the cells were charged (0.33 C) up to 4.45 V in CC-CV mode at 45 °C, and then discharged (0.33 C) up to 2.5 V in CC mode was considered one cycle, and a total of 30 cycles of charging and discharging were repeated, and the discharge capacity at the first cycle and at the 30th cycle was measured, and the measured discharge capacity at the first cycle and at the 30th cycle and a percentage of the discharge capacity at the 30th cycle to the discharge capacity at the first cycle (capacity retention (%)) are shown in Table 8 below.

[Table 6]

| | CHC, 2.5-4.3 V | | |
| --- | --- | --- | --- |
| | @45 °C, 0.33 C | | |
| | Discharge capacity (mAh/g) | | Capacity retention (%) |
| | 1st cycle | 30th cycle | |
| Example 1 | 174 | 169 | 97.1 |
| Comparative Example 1 | 185 | 173 | 93.5 |

As shown in Table 6, it is determined that the battery including the positive electrode active material prepared in Example 1 in the form of a single particle was superior to the battery including the positive electrode active material prepared in Comparative Example 1 in the form of a secondary particle, in capacity retention (%) at high voltages. Specifically, upon charging and discharging, irreversible capacity loss is induced due to degraded grain boundary, and the single particle has a larger particle size than the secondary particle and a smaller number of primary particles, thereby having a smaller grain boundary area. In conclusion, it is seen that the single particle has a small grain boundary area, and thus the irreversible capacity loss is minimized during charging and discharging at high voltages, and accordingly, is relatively stable even during the charge and discharge cycle.

[Table 7]

| | CHC, 2.5-4.45 V | | | | |
| --- | --- | --- | --- | --- | --- |
| | @25 °C, 0.1 C | | | @25 °C, 2 C | 2 C/0.1 C (%) |
| | Charge capacity (mAh/g) | Discharge capacity (mAh/g) | Efficiency (%) | Discharge capacity (mAh/g) | |
| Example 1 | 222 | 199 | 89.6 | 167 | 84 |
| Example 2 | 221 | 198 | 89.7 | 166 | 84 |
| Example 3 | 222 | 199 | 89.7 | 167 | 84 |
| Example 4 | 222 | 199 | 89.6 | 167 | 83 |
| Example 5 | 222 | 198 | 89.2 | 166 | 84 |
| Example 6 | 223 | 200 | 89.7 | 166 | 83 |
| Example 7 | 222 | 198 | 89.2 | 166 | 84 |
| Comparative Example 2 | 221 | 197 | 89.2 | 164 | 83 |
| Comparative Example 3 | 223 | 201 | 90.1 | 167 | 83 |
| Comparative Example 4 | 221 | 196 | 88.7 | 161 | 82 |
| Comparative Example 5 | 220 | 196 | 89.1 | 161 | 82 |
| Comparative Example 6 | 223 | 200 | 89.7 | 176 | 88 |

[Table 8]

| | CHC, 2.5-4.45 V | | |
| --- | --- | --- | --- |
| | @45 °C, 0.33 C | | |
| | Discharge capacity (mAh/g) | | Capacity retention (%) |
| | 1st cycle | 30th cycle | |
| Example 1 | 203 | 197 | 97.0 |
| Example 2 | 202 | 196 | 97.1 |
| Example 3 | 203 | 196 | 96.6 |
| Example 4 | 202 | 195 | 96.3 |

(continued)

| | CHC, 2.5-4.45 V | | |
| --- | --- | --- | --- |
| | @45 °C, 0.33 C | | |
| | Discharge capacity (mAh/g) | | Capacity retention (%) |
| | 1st cycle | 30th cycle | |
| Example 5 | 202 | 193 | 95.5 |
| Example 6 | 203 | 197 | 97.0 |
| Example 7 | 202 | 193 | 95.7 |
| Comparative Example 2 | 200 | 190 | 95.0 |
| Comparative Example 3 | 205 | 194 | 94.7 |
| Comparative Example 4 | 201 | 190 | 94.6 |
| Comparative Example 5 | 200 | 188 | 94.1 |
| Comparative Example 6 | 204 | 195 | 95.2 |

Tables 7 and 8 show that the batteries including the positive electrode active materials prepared in Examples 1 to 7, that is, the positive electrode active materials including a coating layer containing aluminum (Al) and tungsten (W), had high efficiency and 2 C/0.1 C at 25 °C, and high discharge capacity and capacity retention at 45°C. Meanwhile, it is determined that the batteries including the positive electrode active materials prepared in Comparative Examples 2, 4, and 5, that is, the positive electrode active materials not including a coating layer containing both aluminum (Al) and tungsten (W), had low efficiency and 2 C/0.1 C at 25 °C, and low discharge capacity and capacity retention at 45 °C. It is determined that the battery including the positive electrode active material prepared in Comparative Example 3, that is, the positive electrode active material including a coating layer containing tungsten (W) and boron (B), or the battery including the positive electrode active material prepared in Comparative Example 6, that is, the positive electrode active material including a coating layer containing aluminum (Al) and boron (B), had high efficiency and 2 C/0.1 C at 25 °C, but low capacity retention at 45 °C.

In conclusion, it is determined that the positive electrode active material according to the present invention had excellent efficiency and rate characteristics at 25 °C along with high discharge capacity and excellent capacity retention at 45 °C.

**Claims**

1. A positive electrode active material comprising:

   a lithium composite transition metal oxide in the form of a single particle formed of 10 or fewer primary particles, having a nickel (Ni) content of 50 mol% or greater among all metals excluding lithium; and
   a coating layer comprising aluminum (Al) and tungsten (W) formed on the lithium composite transition metal oxide.

2. The positive electrode active material of claim 1, wherein the lithium composite transition metal oxide has a Ni content of 59 mol% to 70 mol% among all metals excluding lithium.

3. The positive electrode active material of claim 1, wherein the lithium composite transition metal oxide has a composition represented by Formula 1 below:

   [Formula 1]     $Li_{1+x}Ni_aCo_bMn_cM_dO_2$

   wherein in Formula 1 above,
   M is at least one selected from Zr, Y, B, Al, W, Mg, Ce, Hf, Ta, La, Ti, Sr, Ba, Ce, F, P, S, and La, and
   x, a, b, c, and d satisfy $-0.100 \leq x \leq 0.100$, $0.5900 \leq a < 1.0000$, $0 < b < 0.4100$, $0 < c < 0.4100$, and $0 \leq d \leq 0.1000$.

4. The positive electrode active material of claim 1, wherein the lithium composite transition metal oxide has a single particle formation degree ($\chi$) of 0.40 or greater according to Equation 1 below:

[Equation 1]

$$\chi = \frac{\text{Average particle size of primary particle } (D'_{50}) \, [\mu m]}{\text{Average particle size of lithium composite transition metal oxide } (D_{50}) \, [\mu m]}$$

.

5. The positive electrode active material of claim 4, wherein the single particle formation degree ($\chi$) ranges from 0.55 to 0.65.

6. The positive electrode active material of claim 1, wherein the primary particles have an average particle size ($D'_{50}$) of 1.0 $\mu$m to 3.5 um.

7. The positive electrode active material of claim 1, wherein the lithium composite transition metal oxide has an average particle size ($D_{50}$) of 2.0 $\mu$m to 5.0 $\mu$m.

8. The positive electrode active material of claim 1, wherein the lithium composite transition metal oxide has an average crystallite size of 120 nm to 200 nm.

9. The positive electrode active material of claim 1, wherein the coating layer is provided in an amount of 0.01 parts by weight to 1.00 part by weight with respect to 100 parts by weight of the lithium composite transition metal oxide.

10. The positive electrode active material of claim 1, wherein the coating layer contains aluminum (Al) in an amount of 500 ppm to 4000 ppm with respect to a total weight of the lithium composite transition metal oxide.

11. The positive electrode active material of claim 1, wherein the coating layer contains tungsten (W) in an amount of 1000 ppm to 4000 ppm with respect to a total weight of the lithium composite transition metal oxide.

12. The positive electrode active material of claim 1, wherein the coating layer comprises at least one selected from an M'-O compound and a Li-M'-O compound, and
M' is at least one selected from Al and W.

13. The positive electrode active material of claim 1, wherein the coating layer is of a film type, island type, or a combination of both.

14. The positive electrode active material of claim 1, having an average particle size of 2.0 $\mu$m to 5.0 $\mu$m.

15. A method for preparing the positive electrode active material according to claim 1, the method comprising:

(A) mixing and firing a composite transition metal hydroxide and a lithium (Li)-containing raw material to prepare a lithium composite transition metal oxide; and
(B) mixing the lithium composite transition metal oxide with an aluminum (Al)-containing raw material and a tungsten (W)-containing raw material to prepare a mixture, and then heat treating the mixture to form a coating layer comprising aluminum (Al) and tungsten (W) on the lithium composite transition metal oxide,

wherein the firing is performed at a temperature of 900°C to 1000°C.

16. The method of claim 15, wherein the aluminum (Al)-containing raw material is mixed to achieve the aluminum (Al) in an amount of 500 ppm to 4000 ppm with respect to a total weight of the lithium composite transition metal oxide.

17. The method of claim 15, wherein the tungsten (W)-containing raw material is mixed to achieve the tungsten (W) in an amount of 500 ppm to 5500 ppm with respect to a total weight of the lithium composite transition metal oxide.

18. The method of claim 15, wherein the aluminum (Al)-containing raw material is at least one selected from oxide, carbonate, nitrate, hydroxide, oxyhydroxide, and halide, containing the aluminum (Al), and
the tungsten (W)-containing raw material is at least one selected from oxide, carbonate, nitrate, hydroxide, oxyhydroxide, and halide, containing the tungsten (W).

19. The method of claim 15, wherein the heat treatment is performed at a temperature of 300 °C to 600 °C.

20. A positive electrode comprising the positive electrode active material according to any one of claims 1 to 14.

21. A lithium secondary battery comprising the positive electrode according to claim 20.

[FIG. 1]

[FIG. 2]

[FIG. 3]

[FIG. 4]

[FIG. 5]

# EP 4 787 469 A1

## INTERNATIONAL SEARCH REPORT

| International application No. |
|---|
| **PCT/KR2024/017100** |

| A. | CLASSIFICATION OF SUBJECT MATTER |
|---|---|

**H01M 4/36**(2006.01)i; **H01M 4/525**(2010.01)i; **H01M 4/505**(2010.01)i; **H01M 4/131**(2010.01)i; **H01M 10/052**(2010.01)i; **C01G 53/00**(2006.01)i; **C30B 29/22**(2006.01)i; **H01M 4/02**(2006.01)i

According to International Patent Classification (IPC) or to both national classification and IPC

| B. | FIELDS SEARCHED |
|---|---|

Minimum documentation searched (classification system followed by classification symbols)

H01M 4/36(2006.01); H01M 4/505(2010.01); H01M 4/525(2010.01); H01M 4/62(2006.01); H01M 50/107(2021.01); H01M 50/533(2021.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 단입자 (single particle), 니켈 (nickel), 알루미늄 (aluminium), 텅스텐 (tungsten), 코팅 (coating), 양극 (cathode), 리튬 이차전지 (lithium secondary battery)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 115863602 A (BASF SHANSHAN BATTERY MATERIALS CO., LTD.) 28 March 2023 (2023-03-28)<br>See abstract; paragraphs [0012], [0021], [0024], [0041] and [0046]; and claims 1, 6, 9 and 10. | 1-3,8-21 |
| Y | | 4-7 |
| Y | KR 10-2023-0053534 A (LG ENERGY SOLUTION, LTD.) 21 April 2023 (2023-04-21)<br>See abstract; paragraphs [0109] and [0117]; and claims 5 and 9. | 4-7 |
| A | JP 2021-174682 A (SUMITOMO CHEMICAL CO., LTD.) 01 November 2021 (2021-11-01)<br>See abstract; paragraphs [0212]-[0216]; and claims 1-22. | 1-21 |
| A | KR 10-2023-0081051 A (COSMO AM&T CO., LTD.) 07 June 2023 (2023-06-07)<br>See abstract; and claims 1-26. | 1-21 |

| ☑ Further documents are listed in the continuation of Box C. | ☑ See patent family annex. |
|---|---|

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 February 2025** | **10 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/017100** |

**C. DOCUMENTS CONSIDERED TO BE RELEVANT**

| Category* | Citation of document, with indication, where appropriate, of the relevant passages | Relevant to claim No. |
|---|---|---|
| A | KR 10-2023-0083416 A (L & F CO., LTD.) 12 June 2023 (2023-06-12)<br>See abstract; and claims 1-19. | 1-21 |

Form PCT/ISA/210 (second sheet) (July 2022)

# EP 4 787 469 A1

**INTERNATIONAL SEARCH REPORT**
**Information on patent family members**

International application No.

**PCT/KR2024/017100**

| Patent document cited in search report | | | Publication date (day/month/year) | Patent family member(s) | | | Publication date (day/month/year) |
|---|---|---|---|---|---|---|---|
| CN | 115863602 | A | 28 March 2023 | WO | 2024-140211 | A1 | 04 July 2024 |
| KR | 10-2023-0053534 | A | 21 April 2023 | CN | 118104037 | A | 28 May 2024 |
| | | | | EP | 4418398 | A1 | 21 August 2024 |
| | | | | JP | 2024-537303 | A | 10 October 2024 |
| | | | | WO | 2023-063779 | A1 | 20 April 2023 |
| JP | 2021-174682 | A | 01 November 2021 | JP | 7460437 | B2 | 02 April 2024 |
| | | | | WO | 2021-220796 | A1 | 04 November 2021 |
| KR | 10-2023-0081051 | A | 07 June 2023 | KR | 10-2024-0152808 | A | 22 October 2024 |
| | | | | KR | 10-2024-0152809 | A | 22 October 2024 |
| | | | | KR | 10-2024-0153299 | A | 22 October 2024 |
| | | | | KR | 10-2734161 | B1 | 25 November 2024 |
| KR | 10-2023-0083416 | A | 12 June 2023 | KR | 10-2023-0083425 | A | 12 June 2023 |
| | | | | US | 2025-0023040 | A1 | 16 January 2025 |
| | | | | WO | 2023-101495 | A1 | 08 June 2023 |

Form PCT/ISA/210 (patent family annex) (July 2022)

30

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230151120
- KR 1020210007808